(19)

Europäisches
Patentamt
European
Patent Office
Office européen
des brevets

(11) **EP 2 105 952 A2**

(12) **EUROPEAN PATENT APPLICATION**

(43) Date of publication:
30.09.2009 Bulletin 2009/40

(51) Int Cl.:
*H01L 21/3065* (2006.01)

(21) Application number: 09156284.3

(22) Date of filing: 26.03.2009

(84) Designated Contracting States:
**AT BE BG CH CY CZ DE DK EE ES FI FR GB GR
HR HU IE IS IT LI LT LU LV MC MK MT NL NO PL
PT RO SE SI SK TR**
Designated Extension States:
**AL BA RS**

(30) Priority: **27.03.2008 US 39912 P**

(71) Applicant: **Dalsa Semiconductor Inc.
Waterloo, Ontario N2V 2E9 (CA)**

(72) Inventor: **Beaudry, Richard
Québec J2M 2A9 (CA)**

(74) Representative: **Harding, Richard Patrick
Marks & Clerk LLP
4220 Nash Court
Oxford Business Park South
Oxford
OX4 2RU (GB)**

(54) **Deep reactive ion etching**

(57)     In a method of performing an anisotropic etch on a substrate in an inductively coupled plasma etch chamber, at least three cycles of a procedure consisting essentially of the four following steps are performed:
a. depositing a protective polymer on a patterned substrate;
b. performing a first low pressure etch to partially remove the deposited protective polymer at a pressure less than 40 mTorr;
c. performing a high pressure etch at a pressure between 40 mTorr and 1000 mTorr to form a portion of a trench in the substrate; and
d. performing a second low pressure etch at a pressure less than 40 mTorr to reduce surface roughness.
    This method permits the fabrication of deep trenches with reduced surface roughness.

## 4-Step Method

**Fig. 11**

Enter the sample in the ICP chamber

Deposition cycle

Deposition removal step

Main Etch step

Roughness removal step

} Etch cycle

Is the anisotropic etching is finished? — No

Yes

Take the sample out of the chamber

## Description

### Field of the Invention

This invention relates to anisotropic etching of substrates, and in particular deep reactive ion etching.

### Background of the Invention

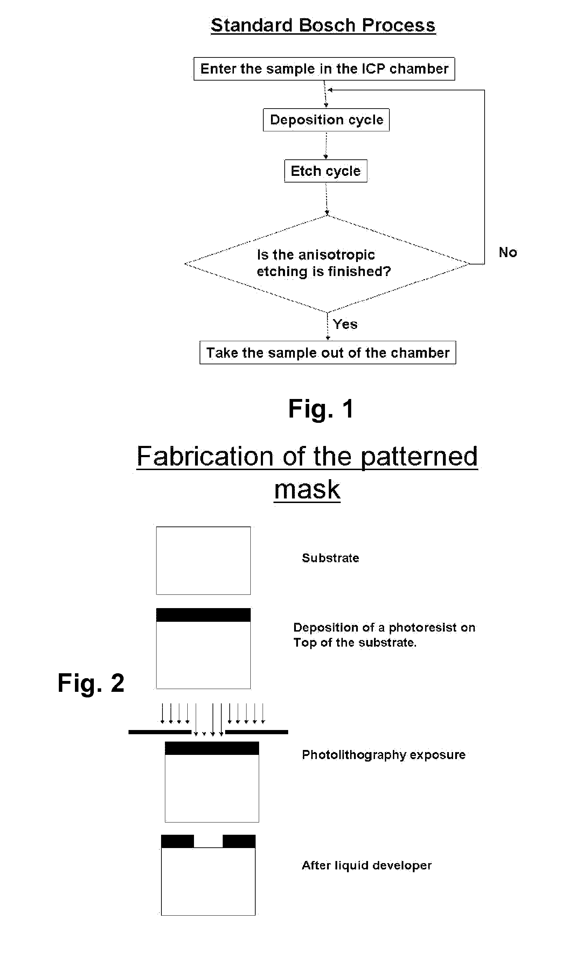

The so-called "Bosch Process" described in US patent Nos. 5,501,893 and 6,127,273, the contents of which are herein incorporated by reference, is for anisotropic etching. This process uses a patterned mask deposited on top of the substrate. The mask needs to be selective to the etching chemistry used for etching the substrate. Then, in an Inductively Coupled Plasma (ICP) system, two plasma conditions are alternated between deposition phase and etching phase. The deposition is done using a gas that deposits a Teflon-like polymer (normally $C_4F_8$ is used) and the etching is normally performed using a fluorine gas to attack the silicon substrate (normally $SF_6$). During the etch cycle, RF power is applied on the substrate to generate an electric field that causes ion bombardment on the bottom of the etch feature (cavity or trench). This removes the polymer only on the bottom of the etch feature and not on the sidewalls. Repeating alternate etching and deposition phases generates an anisotropic etched feature. Fig. 1 shows the sequence diagram of the standard Bosch Process.

The Bosch process normally uses pressure between 5 and 100mTorr. When the etch rate is the main concern for productivity purposes, and sidewall roughness is acceptable to some extent, increasing the pressure above 100mTorr and increasing the ratio between etching time and deposition time are both solutions to achieving a higher etch rate with the same equipment (generally an Inductively Coupled Plasma System). When performing anisotropic etching with Bosch process at high pressure, a rougher bottom surface is observed. This is the root cause for a well-known defect in Deep Reactive Ion Etching (DRIE), which is named "grass". This also generates non-uniformities across the wafer because the roughness is rarely uniform across the wafer. This roughness also causes unwanted sidewall roughness.

The most common technique in the micro fabrication industry used for the fabrication of patterned masks is the photolithography technique. Figure 2 shows an example of how to make the patterned mask. Many other techniques can be used but we will limit our explanation to only one. A silicon wafer substrate is normally used. Then, a photoresist is dispensed on top of the wafer using spin coating technique. A quartz plate with a pattern made of metal on top of it is placed between a shining light and the substrate. Regions in the photoresist where the light reaches the substrate get altered and become soluble. The wafer is then immersed in a liquid (a developer) that can dissolve selectively these altered regions. What is left is an image made of photoresist that is identical to the metal pattern that was on the quartz plate. The outcome of these steps is the sample that is used for anisotropic etching (entered in the ICP chamber in Fig.1).

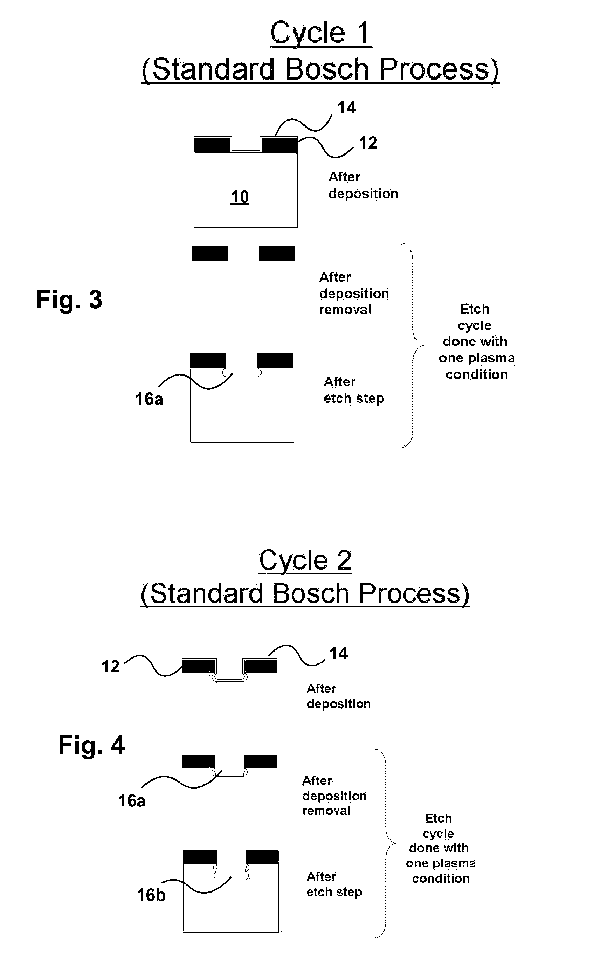

Fig. 3 is a schematic representation of a cross-section of the sample in a standard Bosch process during the three key moments of the first cycle. In order from top to bottom: at the end of the deposition showing the substrate 10, the photoresist 12, and the polymer layer 14, during the etch step after the polymer 14 is completely removed from the bottom, and at the end of the etch step showing the resulting partly formed trench 16a.

Fig. 4 shows a schematic representation of the steps that the sample encounters during the second cycle of the sequence shown in Fig.1 when the answer to the question after the first cycle is "NO". This is called the first scallop of the etching. The trench is further extended as shown at 16b.

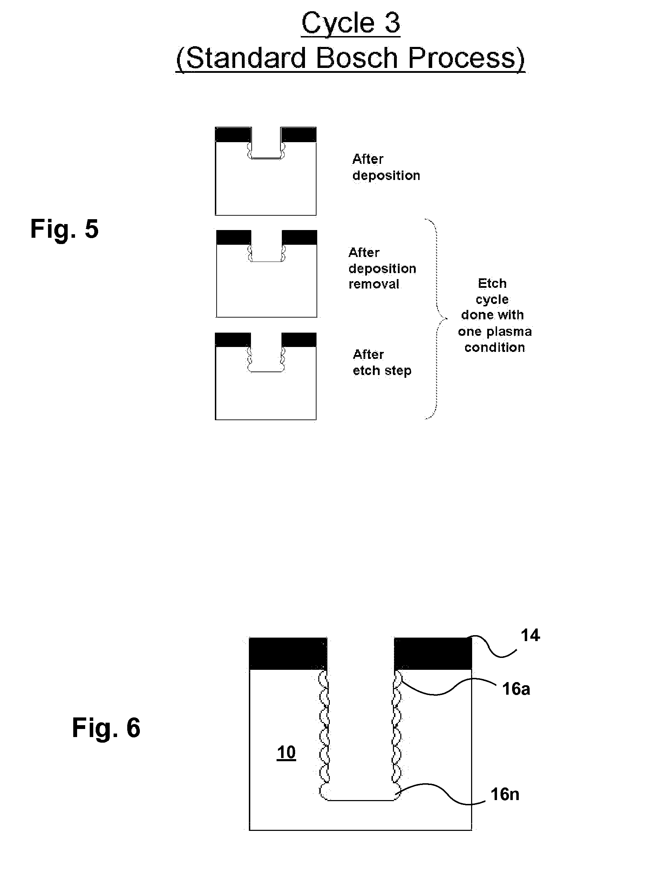

Fig.5 shows a schematic representation of the steps that the sample encounters during the third cycle of the sequence shown in Fig.1 the answer to the question after the second cycle is "NO". Fig. 6 shows the sample after 7 cycles of Standard Bosch Process when successive trench portions 16a to 16n are formed after each cycle. This is repeated until the right depth is obtained. The result is an anisotropic etched feature.

To create smooth sidewalls and soft roughness on the bottom of the etch feature, it is generally recommended to use etch pressure between 1 to 40mTorr. To increase etch rate with that technique the following measures are commonly used:

   a. Increasing pressure on the etch cycle between 40mTorrs and 1 Torrs.

   b. Increasing the ratio between the time of etch and the time of deposition in each cycle.

   c. Increasing the etching gas flow.

   d. Increasing the dissociation of the etching gas by using high RF power on the ICP antenna.

All the above steps generally result in larger scallop dimensions.

When maximizing the etch rate, items a and *b* are the major factors. However, they cause the following disadvantages:

a. Larger roughness on the bottom of the etched feature. After many cycles, this can become dramatic and cause the well known DRIE defect called "grass". Since deposition is deposited on a rough surface, this increases the time to remove it at the next subsequent etch cycle. It then tends to worsen the roughness as the number of cycle is increased. At one point in time, the vertical roughness defect will grow if it is not removed after each cycle. These vertical defect features are the "grass". The roughness on the bottom of the etch feature may not be so serious, but is still.

b. Since the mean free path of the ions is inversely proportional to the pressure, increasing pressure reduces the density of ions that are accelerated without collision in the plasma sheath. This reduces the efficiency of the bombardment but increases its density. During the beginning of each etch cycle; this is increasing the time needed to remove the deposition of the preceding deposition cycle, causing wall etching (wall breakage) and roughness on the bottom of the etched feature.

The second disadvantage has to some extent been overcome by the company Surface Technology Systems (STS) which uses a deposition removal step at the beginning of the etch cycle. The original Bosch process was altered and the "3-Step Method" is defined by the following sequence:

a. Deposition cycle

b. Etch removal step. This usually uses low pressure between 5 and 40mT and high RF power on the platen (RF power on the sample).

c. Main etch step. This usually uses lower platen power. Reducing the platen power gives higher selectivity to the patterned mask (which is a valuable asset). In this step, since the deposition is removed on the bottom after step b, the pressure can be increased to increase the etch rate without the disadvantage b above.

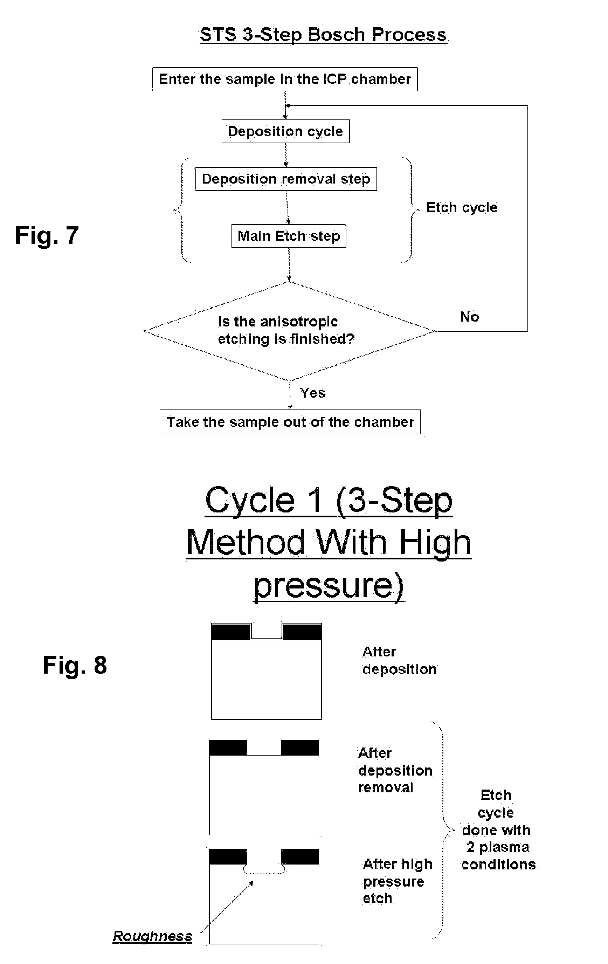

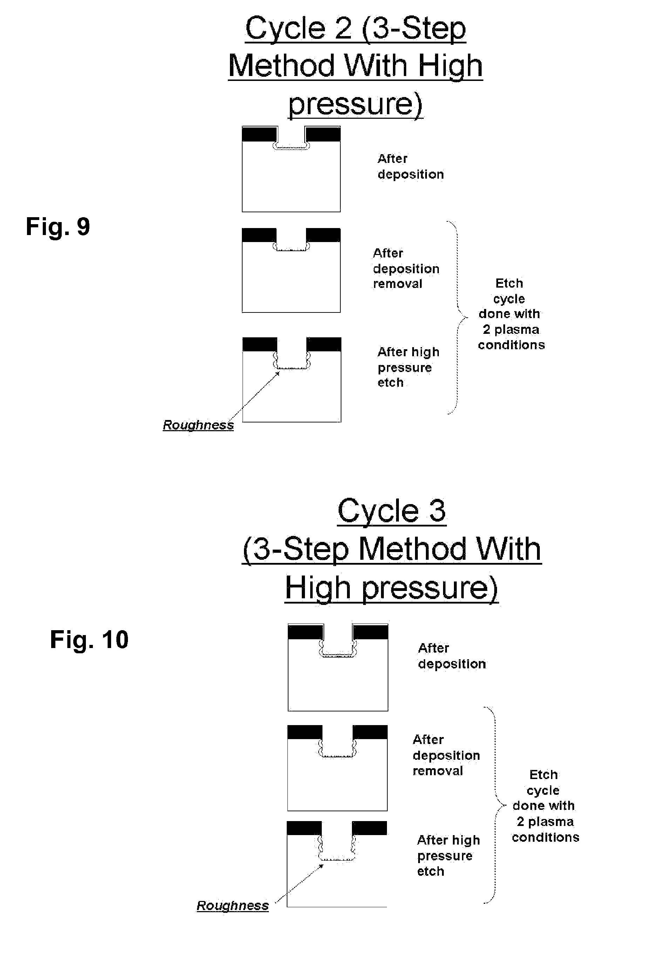

Fig. 7 is a sequence diagram of the 3-step method from STS using high pressure. Fig. 8 shows a schematic representation of the steps that the sample encounters during the first cycle of the sequence shown in Fig. 7. Roughness is observed when using high pressure. Fig. 9 is a schematic representation of the steps that the sample encounters during the second cycle of the sequence shown in Fig. 7 when answering "NO" at the question after the first cycle. Fig. 10 is a schematic representation of the steps that the sample encounters during the third cycle of the sequence shown in Fig. 7 when answering "NO" at the question after the second cycle.
As can be observed, when using the 3-Step Method at high pressure, as the cycles are added, the roughness in the bottom of the etched feature gets worse and worse.

**Summary of the Invention**

This disadvantages of the 3-Step method and the standard 2-step relating to the roughness on the bottom of the etched patterned can be overcome by the in accordance with embodiments of the invention.
According to the present invention there is provided a method of performing an anisotropic etch on a substrate in an inductively coupled plasma etch chamber, comprising performing at least three cycles of a procedure consisting essentially of the four following steps:

a. depositing a protective polymer on a patterned substrate;

b. performing a first low pressure etch to partially remove the deposited protective polymer at a pressure less than 40 mTorr;

c. performing a high pressure etch at a pressure between 40mT and 1000mT to form a portion of a trench in the substrate; and

d. performing a second low pressure etch at a pressure less than 40MTorr to reduce surface roughness.

In one embodiment, the platen power in the inductively coupled plasma etch chamber is greater for steps *b* and *d* than for step *c* and the pressure in step *d* is less than the pressure in step *b*.
Suitably, the substrate is silicon. The protective polymer is deposited using $C_4F_8$ gas, and the etchant gas is selected from the group consisting of $SF_6$, $O_2$ and a combination thereof.

The longer the time of etch at high pressure, the rougher is the bottom surface. The addition of a new step during the etch cycle at low pressure and at high platen power (for efficient ion bombardment) smoothes the bottom of the cavity. This leaves a flat surface prior to the next deposition in the following cycle and prevents the growth of roughness from cycle to cycle. Also, because the deposition is deposited on a flat surface, the time to remove completely the deposition in the next deposition removal step is reduced. This allows higher pressure without roughness on the bottom. Actually, the pressure where the maximum etch rate is obtained can be used with minimal roughness. Because the deposition removal step is reduced, this further increases the etch rate and minimizes attack on the sidewalls.

An important advantage of this technique is that by using this extra step, the limitation at high pressure is minimized. This gives smoother sidewall and bottom features at fast etch rates. Furthermore, by limiting the non-uniformity on the etch rate across the wafer because of the roughness, embodiments of this invention result in a reduction on the depth non-uniformity across the wafer.

The Radio Frequency (RF) coil matching network unit needs to be able to react to the fast change of plasma conditions. Reducing the pressure rapidly corresponds to a fast change in impedance and therefore the matching network unit needs to react fast on such changes. The addition of an extra bombardment step reduces the mask selectivity.

BRIEF DESCRIPTION OF THE DRAWINGS

The invention will now be described in more detail, by way of example only, with reference to the accompanying drawings, in which:-

Fig. 1 is a sequence diagram of the standard Bosch process;

Fig. 2 is a schematic representation in cross-section of the photolithography process normally used to make the patterned mask;

Fig. 3 is a schematic representation of the cross-section of the sample under a standard Bosch process during the 3 key moments of the first cycle. In order from top to bottom: at the end of the deposition, during the etch step after the polymer is completely removed from the bottom, and at the end of the etch step;

Fig. 4 is a schematic representation of the cross-section of the sample under a standard Bosch process during the 3 key moments of the first cycle. In order from top to bottom: at the end of the deposition, during the etch step after the polymer is completely removed from the bottom, and at the end of the etch step;

Fig. 5 is a schematic representation of the cross-section of the sample under a standard Bosch process during the 3 key moments of the first cycle. In order from top to bottom: at the end of the deposition, during the etch step after the polymer is completely removed from the bottom, and at the end of the etch step;

Fig.6 is a schematic representation of the cross-section of the sample under a standard Bosch process after 7 cycles;

Fig. 7 is a sequence diagram of the 3 step STS modified Bosch Process;

Fig. 8 is a schematic representation of the cross-section of the sample under 3-step Bosch Process during the 3 key moments of the first cycle. In order from top to bottom: at the end of the deposition, during the etch step after the polymer is completely removed from the bottom, and at the end of the etch step;

Fig. 9 is a schematic representation of the cross-section of the sample under 3-step Bosch Process during the 3 key moments of the second cycle. In order from top to bottom: at the end of the deposition, during the etch step after the polymer is completely removed from the bottom, and at the end of the etch step;

Fig. 10 is a schematic representation of the cross-section of the sample under 3-step Bosch Process during the 3 key moments of the third cycle. In order from top to bottom: at the end of the deposition, during the etch step after the polymer is completely removed from the bottom, and at the end of the etch step;

Fig. 11 is a sequence diagram of the invention of a four step process in accordance with an embodiment of the invention;

Fig. 12 is a schematic representation of the cross-section of the sample under 4-step process in accordance with an embodiment of the invention during the four key moments of the first cycle. In order from top to bottom: at the end of the deposition, during the etch step after the polymer is completely removed from the bottom, and at the end of the etch step;

Fig. 13 is a schematic representation of the cross-section of the sample under 4-step process in accordance with an embodiment of the invention during the 3 key moments of the second cycle. In order from top to bottom: at the end of the deposition, during the etch step after the polymer is completely removed from the bottom, and at the end of the etch step;

Fig. 14 is a schematic representation of the cross-section of the sample under 4-step process during the 3 key moments of the third cycle. In order from top to bottom: at the end of the deposition, during the etch step after the polymer is completely removed from the bottom, and at the end of the etch step;

Fig. 15 is a SEM micrograph of a cavity on the center of the Sample A. Top: Whole cross-section of the square cavity. Bottom left: Focus on the back wall. Bottom right: Zoom of the photoresist mask and the etch undercut;

Fig. 16 is a SEM micrograph of a cavity on the top (opposite to major flat) of the Sample A. Top: Whole cross-section of the square cavity. Bottom left: Focus on the back wall. Bottom right: Zoom of the photoresist mask and the etch undercut;

Fig. 17 is a SEM micrograph of a cavity on the right hand side (considering the major flat on the bottom) of the Sample A. Top: Whole cross-section of the square cavity. Bottom left: Focus on the back wall. Bottom right: Zoom of the photoresist mask and the etch undercut;

Fig. 18 is a SEM micrograph of a cavity on the center of the Sample B. Top: Whole cross-section of the square cavity. Bottom left: Focus on the back wall. Bottom right: Zoom of the photoresist mask and the etch undercut;

Fig. 19 is a SEM micrograph of a cavity on the top (opposite to major flat) of the Sample B. Top: Whole cross-section of the square cavity. Bottom left: Focus on the back wall. Bottom right: Zoom of the photoresist mask and the etch undercut.

Fig. 20 SEM micrograph of a cavity on the right hand side (considering the major flat on the bottom) of the Sample B. Top: Whole cross-section of the square cavity. Bottom left: Focus on the back wall. Bottom right: Zoom of the photoresist mask and the etch undercut;

Fig. 21 is a comparison of wall roughness between Fig 17 (above from Sample A) and Fig. 20(below from Sample B) on the same site on each sample. The inlet of each image shows the whole cross-section;

Fig. 22 is a microscope image on the two worst dice of the wafer in term of roughness for the Sample A. Left hand side image: Top of the wafer. Right hand side: Right of the wafer;

Fig. 23 is a microscope image on the two worst dice of the wafer in term of roughness for the Sample B. Left hand side image: Top of the wafer. Right hand side: Right of the wafer;

Fig. 24 shows the measured dimensions on SEM micrograph for the evaluation of the profile angle. The inlet shows a diagram of the shape at the bottom of a square cavity. The 3 black lines show 3 possible cross-section lines;

Fig. 25 shows the measured dimensions on SEM micrograph for the evaluation of the profile angle of the back wall. The inlet shows a diagram of the shape at the bottom of a square cavity. The black line shows the plan in which the measurement is done; and

Fig. 26 shows the measured dimensions on SEM micrograph for the photoresist end thickness, the undercut and the scallop size.

DETAILED DESCRIPTION OF PREFERRED EMBODIMENTS

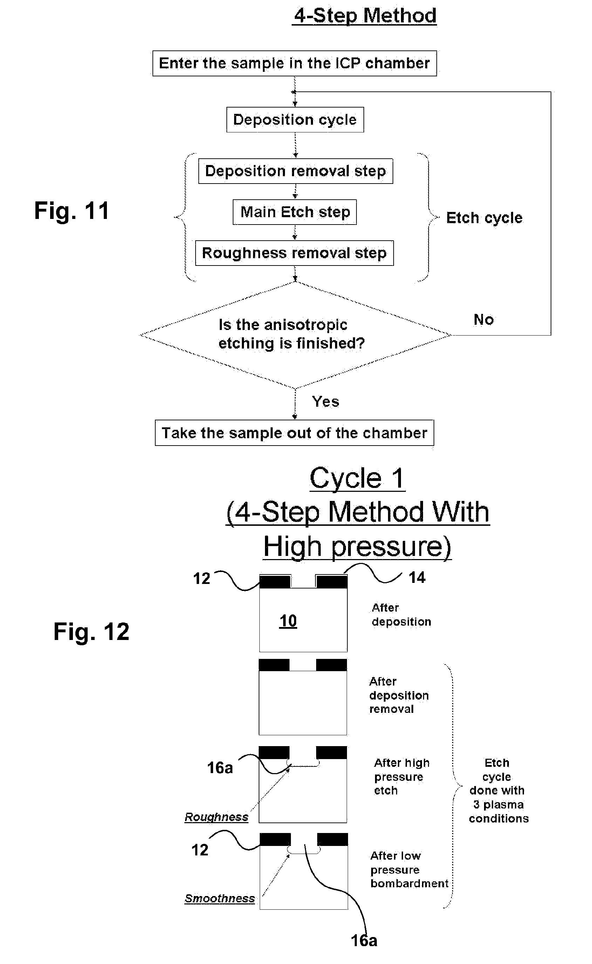

Figure 11 shows a sequence diagram in accordance with an embodiment of the present invention. After the substrate has been patterned with a photoresist mask, such as depicted in Fig.2 or by any other technique, the sample is placed in the ICP chamber. After being clamped on the platen (or chuck) and the process conditions have been stabilized in flow and pressure, the plasma is then lit, and the sample undergoes a deposition, followed by the etching step that removes the deposition. Next, comes a high pressure etching (main etch) as in the 3-step process shown in Figure 7. Finally, the cycle finishes with another bombardment condition at low pressure and high platen power prior to the next cycle, making a total of four steps per cycle. These four steps are repeated until the right depth is obtained or if an underneath etch stop layer is reached.

Fig. 12 is a schematic representation of the steps that the sample encounters during the first cycle of the sequence shown in Fig. 11. In the first step the polymer is deposited as explained with reference to Figure 3. This polymer is removed in the second step at least from the surface of the photoresist and the bottom of the opening in the photoresist layer 12. The polymer may remain on the sidewalls, but this remaining layer is not shown in the drawings.

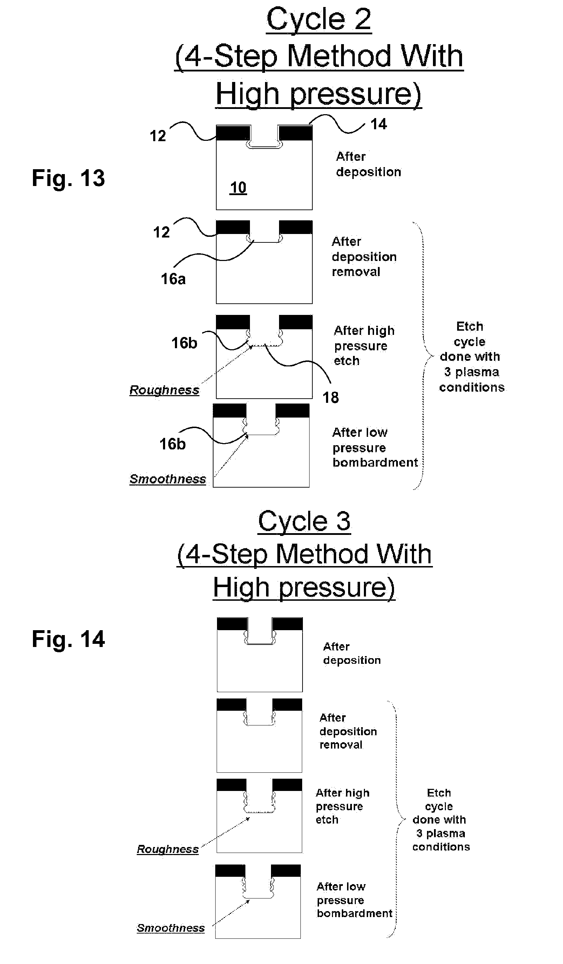

In the third step, the high pressure etch is performed to form the first portion 16a of the trench, and then the fourth step is performed to remove any surface roughness. Figure 13 shows the formation of the second portion 16b of the trench in the third step. This is formed with surface roughness 18, which is removed in the fourth step before starting the third cycle as shown in Figure 14.

Figures 13 and 14 schematize the 4-step method when using high pressure in the main etch step for subsequent cycles 2 and 3. At the end of the high pressure main etch step in each cycle, roughness is observed as in the case of the 3-step method. The roughness removal step then smoothes the surface.

EXPERIMENTAL RESULTS

Using a STS Pegasus silicon ICP chamber, we etched two samples: one was using the prior art 3-Step Method" and one using the 4-Step Method" in accordance with embodiments of the present invention. This was etched on 150mm silicon wafers with a negative photoresist mask that exhibits square and circle features. Both show about 1000$\mu$m of width or diameter. About 29% of the total surface is not masked on the wafer where silicon is exposed to etching. Table 4.2.1 and Table 4.2.2 show all parameters that were used for the Sample A (using the 3-Step Method) and Sample B (using the 4-Step Method) respectively.

**Table 4.2.1 Recipe parameters for a 3-Step Method: SAMPLE A**

| Parameters | | Deposition | Removal Etch Step | High Pressure Etch step |
|---|---|---|---|---|
| Total time (mm :ss) | 19:00 | | | |
| Cycle time | | 5s | 1.5s | 7.5s |
| Pressure (mTorrs) : | | 35 mTorr | 20mT | 325mT |
| Gases (sccm) : | | | | |
| C4F8 | | 250sccm | 0 | 0 |
| O2 | | 0 | 0 | 10 sccm |
| SF6 | | 0 | 250 sccm | 1000 |
| | | | | |
| Generators Coil 13.56 MHz (W) | | 2700 W | 4800W | 4800W |
| Generators Platen 13.56 KHz(W) | | 0 | 170W | 50W |
| Platen Temperatures (°C) | | 0 | 0 | 0 |
| Back side cooling gas = Helium (Torrs) | | 10 | 10 | 10 |

**Table 4.2.2 Recipe parameters for a 4-Step Method: SAMPLE B**

| Parameters | | Deposition | Removal Etch Step | High Pressure Etch step | Low pressure bombardment etch step |
|---|---|---|---|---|---|
| Total time (mm :ss) | 19:00 | | | | |
| Cycle Time | | 5s | 1.5s | 7.5s | 1s |
| Pressure (mTorrs) : | | 35 mTorr | 20mT | 325mT | 15mT |
| Gases (sccm) : | | | | | |
| C4F8 | | 250sccm | 0 | 0 | 0 |
| O2 | | 0 | 0 | 10 sccm | 1 sccm |
| SF6 | | 0 | 250 sccm | 1000 | 250 sccm |
| | | | | | |
| Generators Coil 13.56 MHz (W) | | 2700 W | 4800W | 4800W | 4800W |
| Generators Platen 13.56 KHz(W) | | 0 | 170W | 50W | 150W |
| Platen Temperatures (°C) | | 0 | 0 | 0 | 0 |
| Back side cooling gas = Helium (Torrs) | | 10 | 10 | 10 | 10 |

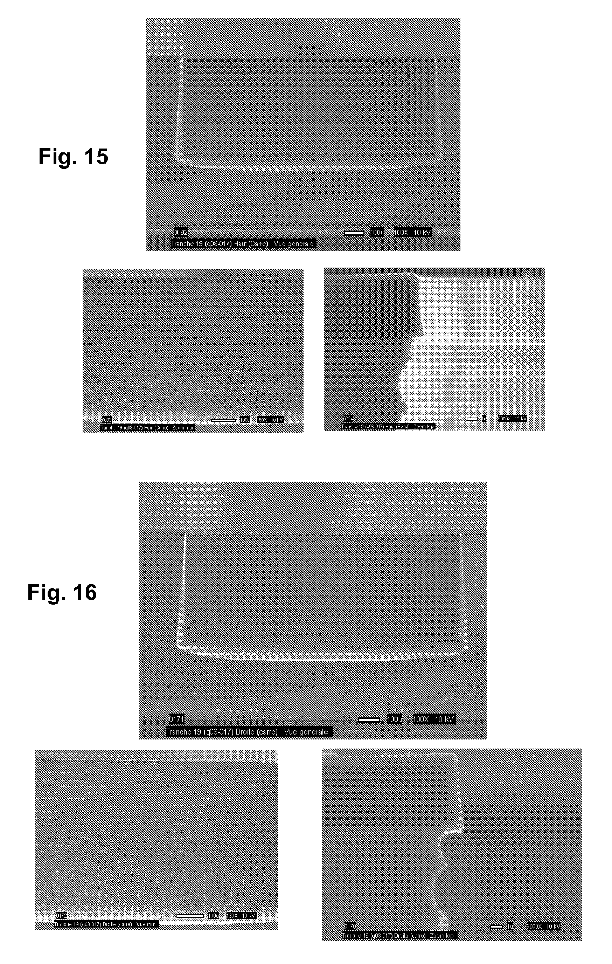

The following images (Fig 15 to 17) show Scanning Electron Microscopy (SEM) images coming from a few sites on Sample A.

Fig. 15 is a SEM micrograph of a cavity on the center of the Sample A. Top: Whole cross-section of the square cavity. Bottom left: Focus on the back wall. Bottom right: Zoom of the photoresist mask and the etch undercut.

Fig. 16 is a SEM micrograph of a cavity on the top (opposite to major flat) of the Sample A. Top: Whole cross-section of the square cavity. Bottom left: Focus on the back wall. Bottom right: Zoom of the photoresist mask and the etch undercut.

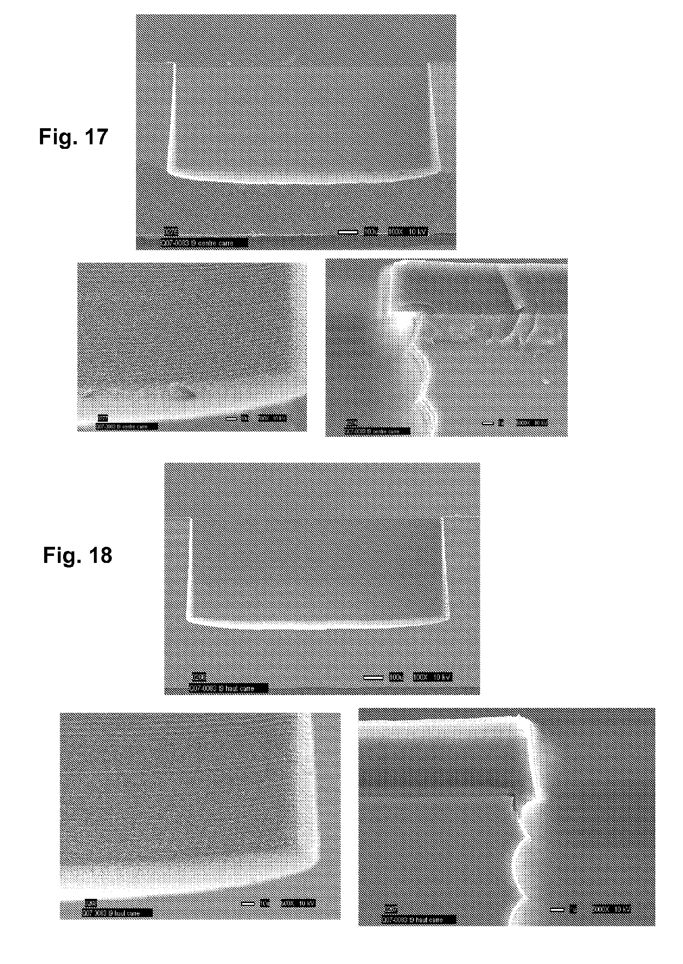

Fig. 17 is a SEM micrograph of a cavity on the right hand side (considering the major flat on the bottom) of the Sample A. Top: Whole cross-section of the square cavity. Bottom left: Focus on the back wall. Bottom right: Zoom of the photoresist mask and the etch undercut.

Figs. 18 to 20 are Scanning Electron Microscopy (SEM) images coming from a few sites on Sample B. The same sites as Sample A were observed.

Fig. 18 is a SEM micrograph of a cavity on the center of the Sample B. Top: Whole cross-section of the square cavity. Bottom left: Focus on the back wall. Bottom right: Zoom of the photoresist mask and the etch undercut.

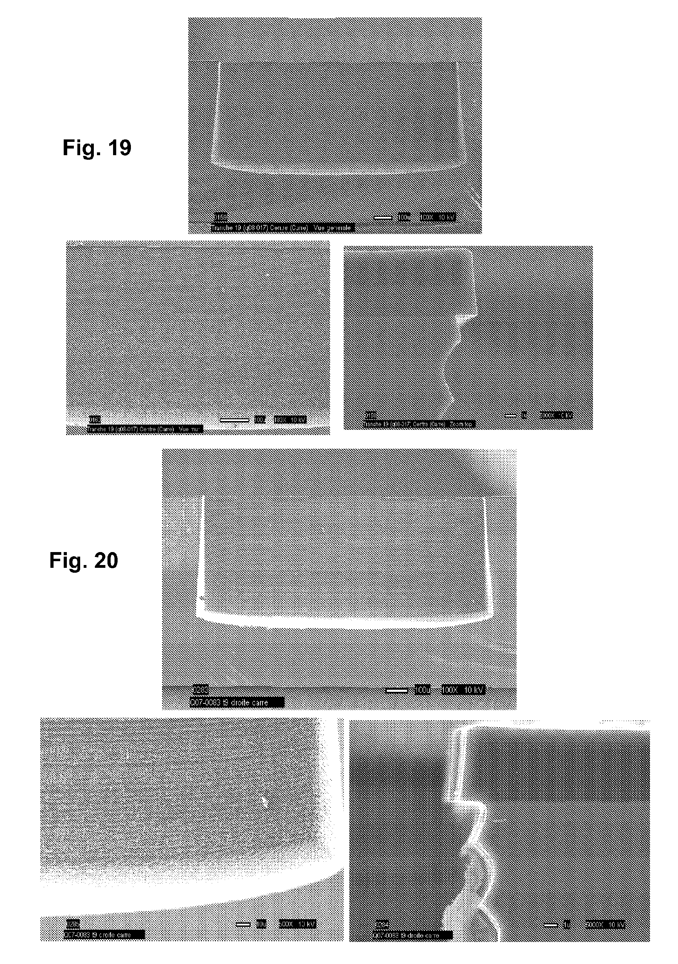

Fig. 19 is a SEM micrograph of a cavity on the top (opposite to major flat) of the Sample B. Top: Whole cross-section of the square cavity. Bottom left: Focus on the back wall. Bottom right: Zoom of the photoresist mask and the etch undercut.

Fig. 20 is a SEM micrograph of a cavity on the right hand side (considering the major flat on the bottom) of the Sample B. Top: Whole cross-section of the square cavity. Bottom left: Focus on the back wall. Bottom right: Zoom of the photoresist mask and the etch undercut.

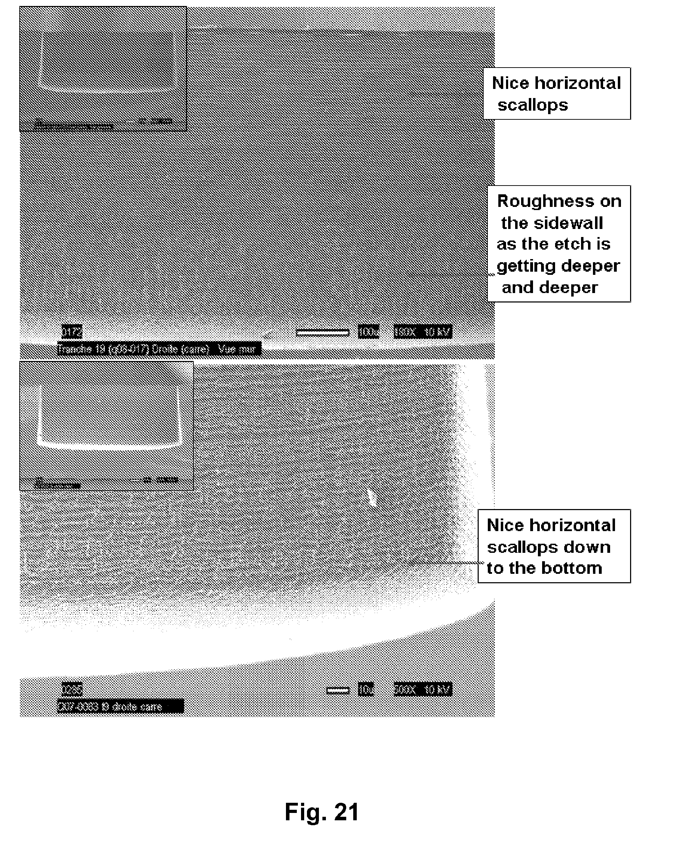

Fig. 21 shows a comparison of the wall roughness for the same site on each sample (right hand side of the wafer). One can observe that Sample A (above image) has horizontal scallops on top of the etch feature (near the surface) which degrade into a mix of vertical and horizontal lines on the bottom sidewall. The vertical lines are caused by roughness that is carried down to the bottom of the cavity. This was depicted in Figs. 7, 8 and 9. The roughness is observed on the bottom of the cavity. However, the sidewall roughness is usually more inconvenient than roughness on the bottom of the cavity. Nevertheless they are created at the same time during the high pressure main etch step of each Bosch cycle. On the Sample B (bottom image) this is not seen and continuous horizontal scallops are observed down to the bottom of the sidewall. Note that the two SEM micrographs are not at the same magnifications.

The above explanation demonstrates that Sample A recipe will be limited at some depth because sidewall and bottom roughness will worsen as the etch gets deeper. Sample B recipe does not show limitation yet at this depth. Furthermore, these vertical lines seen in Sample A demonstrate limitation in depth for such recipe for some commercial applications where sidewall roughness is specified tightly. This also demonstrates that this recipe has a maximum limit in depth for which it can be used. Roughness can only get worse with the same recipe and eventually, "grass" will appear if we etch further down. Sample B recipe does not show such limitations; therefore that recipe is less sensitive to generate grass. Therefore, for the same specification in roughness, the Sample B recipe will be limited at a depth that is greater than for the Sample A recipe. Without using the 4-step method in accordance with embodiments of the invention, the Sample A recipe would have to be modified in order to meet tight specification, and necessarily, the etch rate would be lowered to accommodate smoother sidewalls and smoother bottom surfaces. Either pressure, total time of a Bosch cycle, or the etch-to-deposition ratio would be reduced. Both would result in lower etch rates.

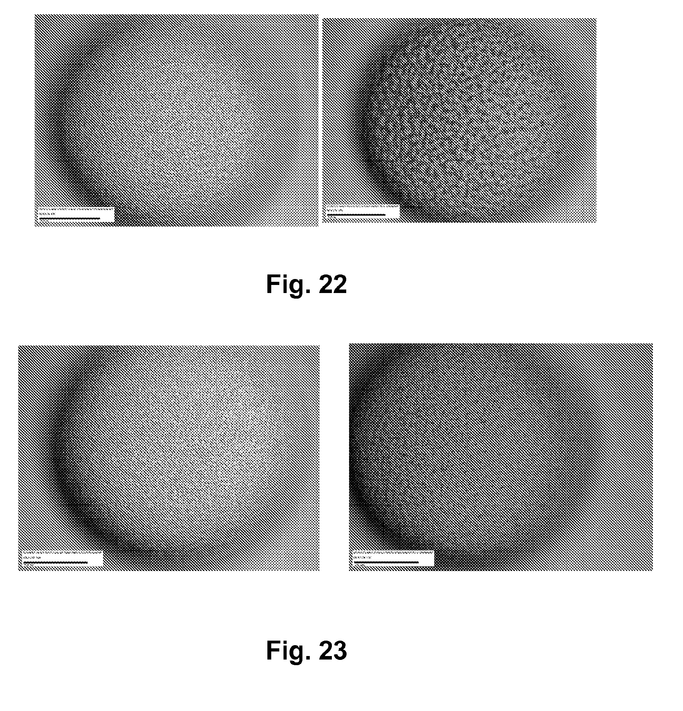

Figs. 22 and Fig. 23 are microscope images at 10X, on the roughest die on two regions for both wafer (the two worst regions). The same dice were compared on both wafers. The focus is on the bottom of the cavity. We observe that Sample B has slightly less roughness on the bottom compared to Sample A.

Fig. 22 is a microscope image on the two worst dice of the wafer in term of roughness for the Sample A. Left hand side image: Top of the wafer. Right hand side: Right of the wafer.

Fig. 23 is a microscope image on the two worst dice of the wafer in term of roughness for the Sample B. Left hand side image: Top of the wafer. Right hand side: Right of the wafer.

Table 4.2.3 shows the results obtained for both samples. Three site were measured on each sample for all measurements: center of the wafer, top of the wafer (opposite to major flat) and on the right side of the wafer. We observed that the etch rates are similar from one to the other. However, the uniformity across the wafer is much better on Sample B. The non-uniformity across the wafer was evaluated as follows:

$$\text{Non-Uniformity} = (\text{Maximum depth} - \text{Minimum depth}) / (2 \times \text{Average depth}) \quad \{\text{EQUATION \#1}\}$$

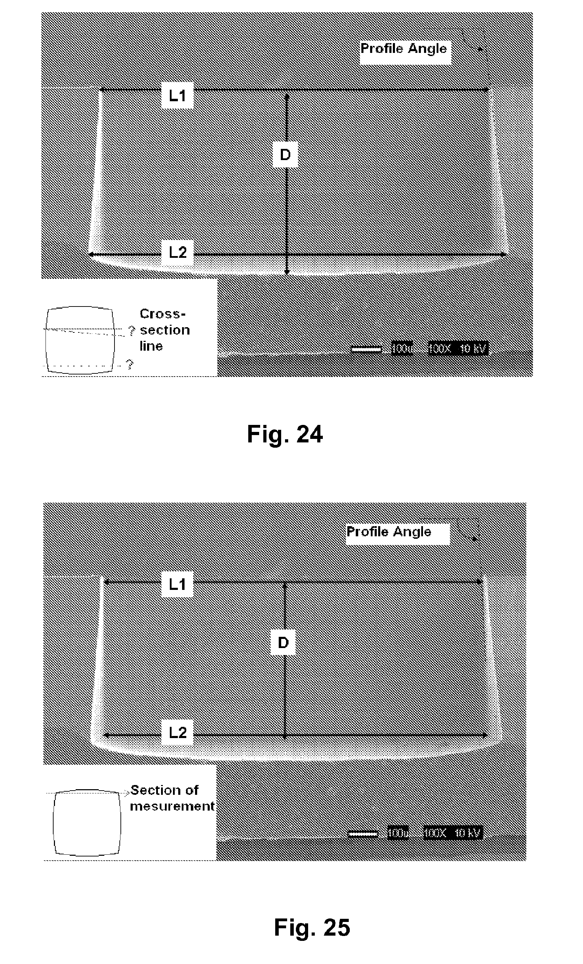

Fig. 25 shows the dimensions we measured to evaluate the profile angle. This is the standard way to measure the profile angle in the DRIE field. The Profile Angle is then obtained with the following equation:

$$\phi = 90+arctan\ [(L2\text{-}L1)\ /\ (2^*D)] \qquad \{EQUATION\ \#2\}$$

The inset of Fig. 24 depicts the shape of the bottom of the cavity for a square mask opening when the profile is re-entrant (i.e. profile angle > 90°). The cleavage of such structure is difficult and the position of the cross-section line will vary from one to another. Therefore the profile angle evaluated in Table 4.2.3 is only indicative and no uniformity was evaluated.

Fig.25 shows the measured dimensions used to measure the profile angle of the back wall. The same Equation 2 was used. This measurement does not depend on the cross-section line and is therefore reproducible form one to another. This measure was used to compare objectively the two profiles. We observe that the averages are identical but that less variation is observe across the wafer for Sample B. This can be potentially explained with the fact that Sample B recipe well clears the roughness on the bottom of the cavity up to the corner of the cavity at each cycle.

**Table 4.2.3 Obtained parameters both sample**

| Parameter | Sample A Results | Sample B Results |
|---|---|---|
| Etch Rate (um/min) and $\pm$ uniformity across the wafer | 24.61 um/min $\pm$ 3.4% | 25.18 um/mm $\pm$ 1.8% |
| Profile angle | 93.45° | 93.42° |
| Profile angle on the back wall | 90.5° $\pm$ 0.25° | 90.6° $\pm$ 0.08° |
| Undercut | 1.35 to 2.95 um per side | 2.1 to 2.65 um per side |
| Scallop size | < 1.75um | < 1.75um |
| Selectivity to resist | 163:1 | 112:1 |

Fig. 24 shows the measured dimensions on SEM micrograph for the evaluation of the profile angle. The inset shows a diagram of the shape at the bottom of a square cavity. The three lines show three possible cross-section lines.

Fig. 25 shows the measured dimensions on SEM micrograph for the evaluation of the profile angle of the back wall. The inset shows a diagram of the shape at the bottom of a square cavity. The red line shows the plan in which the measurement is done.

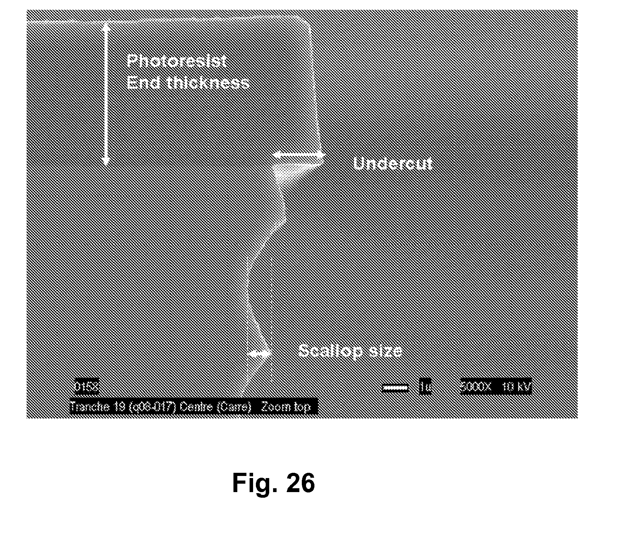

Fig 26 shows the dimensions where we measured the photoresist end thickness, the undercut and the scallop size. The undercut is the distance between the opening of the photoresist mask and the lateral edge of the first scallop. The Sample A undercut shows less uniform undercut across the wafer. It is not sure at this point if this is due to the fourth step on the first cycle. The scallop size is the horizontal dimension of the second scallop. We measure this particular scallop because the scallops tend to diminish in size as the etch goes deeper. Therefore this scallop is assumed to be the largest on each cavity. This value is identical on both samples. This dimension mainly depend on the high pressure etch step. Since this step is identical in both recipes, it is normal to find the same result. The selectivity is defined as follow:

$$Selectivity = (Depth\ of\ the\ cavity)\ /\ [(Initial\ Photoresist\ thickness)\ \text{-}\ (Photoresist\ end\ thickness)]$$

$$\{EQUATION\ \#3\}$$

In Equation 3, we used the average depth of the cavity, an initial thickness of $10\pm0.1\mu m$ (guarantied specification for this photolithography manufactured mask), and the minimum end thickness found on each wafer. Therefore this selectivity is the worst case found in all measurements. The fact that Sample B has a lower selectivity was expected since more ion bombardment is used at each cycle. However, selectivity greater than 100:1 is generally considered in the industry as out standing for such etching.

The above results show that the following advantages can be achieved compared to the 3-step method:

Better uniformity on the etch rate

Better profile uniformity

Better uniformity on the undercut.

No unwanted vertical roughness on the sidewalls

Less roughness is observed on the bottom of the cavity

For the same roughness specifications, embodiments of this invention can use higher etch rate and also can be used up to larger depths.

Embodiments of the present invention when compared to the 3-step method results in a similar profile angle, a similar etch rate, the same scallop size, and a similar undercut.

Embodiments of the present invention also prevent the worsening of the bottom roughness, and therefore allow the use of high pressure without its associated disadvantages. It also pushes further the theoretical limit of the maximum depth that can be achieved with the standard Bosch process.

## Claims

1. A method of performing an anisotropic etch on a substrate in an inductively coupled plasma etch chamber, comprising performing at least three cycles of a procedure consisting essentially of the four following steps:

   a. depositing a protective polymer on a patterned substrate;
   b. performing a first low pressure etch to partially remove the deposited protective polymer at a pressure less than 40 mTorr;
   c. performing a high pressure etch at a pressure between 40 mTorr and 1000 mTorr to form a portion of a trench in the substrate; and
   d. performing a second low pressure etch at a pressure less than 40 mTorr to reduce surface roughness.

2. A method as claimed in claim 1, wherein platen power in the inductively coupled plasma etch chamber is greater for steps *b* and *d* than for step *c*.

3. A method as claimed in claim 1 or 2, wherein the pressure in step *d* is less than the pressure in step *b*.

4. A method as claimed in any one of claims 1 to 3, wherein the substrate is silicon.

5. A method as claimed in any one of claims 1 to 4, wherein the protective polymer is deposited using $C_4F_8$ gas.

6. A method as claimed in any on of claims 1 to 5, wherein the low pressure etch in step *b* is performed in the presence of a gas selected from the group consisting of $SF_6$, $O_2$ and a combination thereof.

7. A method as claimed in any one of claims 1 to 6, wherein the second low pressure etch is performed in the presence of a gas selected from the group consisting of $SF_6$, $O_2$ and a combination thereof.

8. A method as claimed in any one of claims 1 to 7, wherein the high pressure etch is performed in the presence of a gas selected from the group consisting of $SF_6$, $O_2$ and a combination thereof.

9. A method as claimed in any one of claims 1 to 8, wherein the low pressure etch in step *b* is performed at a pressure of about 20 mTorr and the low pressure etch in step *d* is performed at a pressure of about 15 mTorr.

10. A method as claimed in any one of claims 1 to 3, wherein at the end of each cycle after the second, a decision is made as to whether the trench is sufficiently deep, and if yes, the substrate is removed from the inductively coupled plasma chamber.

## Standard Bosch Process

Enter the sample in the ICP chamber

Deposition cycle

Etch cycle

Is the anisotropic
etching is finished?    No

Yes

Take the sample out of the chamber

# Fig. 1

# Fabrication of the patterned mask

**Fig. 2**

Substrate

Deposition of a photoresist on
Top of the substrate.

Photolithography exposure

After liquid developer

# Cycle 1
## (Standard Bosch Process)

**Fig. 3**

After
deposition

After
deposition
removal

After
etch step

Etch
cycle
done with
one plasma
condition

# Cycle 2
## (Standard Bosch Process)

**Fig. 4**

After
deposition

After
deposition
removal

After
etch step

Etch
cycle
done with
one plasma
condition

## Cycle 3
## (Standard Bosch Process)

**Fig. 5**

After deposition

After deposition removal

Etch cycle done with one plasma condition

After etch step

**Fig. 6**

14

16a

10

16n

## STS 3-Step Bosch Process

**Fig. 7**

Enter the sample in the ICP chamber

Deposition cycle

Deposition removal step

Main Etch step

} Etch cycle

Is the anisotropic etching is finished?

No

Yes

Take the sample out of the chamber

# Cycle 1 (3-Step Method With High pressure)

**Fig. 8**

After deposition

After deposition removal

After high pressure etch

Etch cycle done with 2 plasma conditions

*Roughness*

## Cycle 2 (3-Step Method With High pressure)

**Fig. 9**

After deposition

After deposition removal

After high pressure etch

Etch cycle done with 2 plasma conditions

*Roughness*

## Cycle 3 (3-Step Method With High pressure)

**Fig. 10**

After deposition

After deposition removal

After high pressure etch

Etch cycle done with 2 plasma conditions

*Roughness*

## 4-Step Method

**Fig. 11**

Enter the sample in the ICP chamber

Deposition cycle

Deposition removal step

Main Etch step

Roughness removal step

Etch cycle

Is the anisotropic etching is finished?

No

Yes

Take the sample out of the chamber

## Cycle 1
## (4-Step Method With High pressure)

**Fig. 12**

12    14

10

After deposition

After deposition removal

16a

Roughness

After high pressure etch

Etch cycle done with 3 plasma conditions

12

Smoothness

After low pressure bombardment

16a

## Cycle 2
## (4-Step Method With
## High pressure)

**Fig. 13**

12 — 14
After deposition
10

12
16a
After deposition removal

16b
Roughness
After high pressure etch
18

Etch cycle done with 3 plasma conditions

16b
Smoothness
After low pressure bombardment

## Cycle 3
## (4-Step Method With
## High pressure)

**Fig. 14**

After deposition

After deposition removal

Roughness
After high pressure etch

Etch cycle done with 3 plasma conditions

Smoothness
After low pressure bombardment

Fig. 15

Fig. 16

**Fig. 17**

**Fig. 18**

**Fig. 19**

**Fig. 20**

Nice horizontal
scallops

Roughness on
the sidewall
as the etch is
getting deeper
and deeper

Nice horizontal
scallops down
to the bottom

Fig. 21

**Fig. 22**

**Fig. 23**

**Fig. 24**

**Fig. 25**

**Fig. 26**

**EP 2 105 952 A2**

## REFERENCES CITED IN THE DESCRIPTION

**Patent documents cited in the description**

- US 5501893 A

- US 6127273 A